(19) Europäisches Patentamt
European Patent Office
Office européen des brevets

(11) **EP 4 712 291 A1**

(12) **EUROPEAN PATENT APPLICATION**

(43) Date of publication:
**18.03.2026 Bulletin 2026/12**

(51) International Patent Classification (IPC):
*H02J 3/32* $^{(2026.01)}$     *H02J 7/82* $^{(2026.01)}$
*H02J 7/90* $^{(2026.01)}$     *H02J 7/94* $^{(2026.01)}$

(21) Application number: **25199209.5**

(52) Cooperative Patent Classification (CPC):
**H02J 7/855; H02J 3/32; H02J 7/82; H02J 7/933;
H02J 7/94;** H02J 2105/10; H02J 2105/42

(22) Date of filing: **29.08.2025**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **11.09.2024 KR 20240124335**

(71) Applicant: **SAMSUNG SDI CO., LTD.**
**Yongin-si, Gyeonggi-do 17084 (KR)**

(72) Inventor: **KIM, Jae Soon**
**17084 Yongin-si (KR)**

(74) Representative: **Marks & Clerk LLP**
**15 Fetter Lane**
**London EC4A 1BW (GB)**

(54) **SYSTEM AND METHOD FOR PROVIDING USABLE DISCHARGE ENERGY INFORMATION BASED ON CONSUMPTION POWER**

(57) A system and method for providing UDE information based on consumption power are provided. The system for providing UDE information based on consumption power includes a state-of-charge (SOC) calculation unit configured to calculate an SOC ($S_{oc}$) of a battery, a discharge efficiency calculation unit configured to calculate discharge efficiency ($C_{rate}$) information by receiving battery discharge current information, a facility efficiency calculation unit configured to calculate facility efficiency information ($F_E$) by receiving chiller ($C_1$) information and heating, ventilation & conditioning (HVAC) (H) information, and a UDE calculation unit configured to calculate UDE based on the facility efficiency information ($F_E$).

FIG. 1

**Description**

**BACKGROUND**

**1. Field**

Aspects of embodiments of the present disclosure relate to a system and method for providing usable discharge energy (UDE) information based on consumption power.

**2. Description of the Related Art**

An energy storage system (ESS) is a system that improves energy usage efficiency by providing high capacity electric energy storage and supplying the stored electric energy when the electric energy is needed. The ESS may include a battery system, a battery management system (BMS) that manages the battery system, such as by managing a voltage, current, and temperature of the battery system, a power conversion system (PCS) that performs alternating current (AC) to direct current (DC) conversion and power distribution functions, and an energy management system (EMS) that controls an energy flow of the ESS and integrates and controls the entire system of the ESS, such as collecting and managing information, such as the state of the ESS.

During ESS operation, the state of charge (SOC) of a battery is an important factor and is provided (or calculated) by using SOC operation algorithms having various methods based on a cell voltage, temperature, and current of a battery.

A battery manufacturer provides SOC information of a battery on the basis of the charging level of the battery and must be considered in view of the entire consumption power in addition to the SOC of the battery from an energy storage system operation perspective. The ESS is supplied and installed in a container box form centering around a large-scale project. In such a case, consumption power information of the ESS is not provided in a form considering in which a facility, such as an air-conditioning system, in addition to a battery has been mounted.

The above information disclosed in this Background section is for enhancement of understanding of the background of the present disclosure, and therefore, it may contain information that does not constitute related (or prior) art.

**SUMMARY**

Embodiments of the present disclosure are directed to providing a system and method for providing usable discharge energy (UDE) information based on consumption power, which provides UDE by considering the SOC of a battery and consumption power of an air-conditioning system and electrical facility of an ESS system.

However, aspects and features of the present disclosure are not limited to those described above, and other aspects and features of not mentioned herein will be clearly understood by those skilled in the art from the description of the present disclosure below.

A system for providing usable discharge energy (UDE) information based on consumption power, according to an embodiment of the present disclosure, includes a state-of-charge (SOC) calculation unit configured to calculate an SOC of a battery, a discharge efficiency calculation unit configured to calculate discharge efficiency ($C_{rate}$) information by receiving battery discharge current information, a facility efficiency calculation unit configured to calculate facility efficiency information ($F_E$) by receiving chiller ($C_1$) information and heating, ventilation & conditioning (HVAC) ($H$) information, and a UDE calculation unit configured to calculate UDE based on the SOC ($S_{oc}$), the discharge efficiency ($C_{rate}$) information, and the facility efficiency information ($F_E$).

In embodiments, the system for providing UDE information based on consumption power may further include a charging mode determination unit configured to identify a battery charging state. The UDE calculation unit may calculate the UDE when the charging mode determination unit determines that the battery is not being charged.

In embodiments, the facility efficiency calculation unit may calculate the chiller information ($C_1$) based on fan speed and LPM information of the chiller.

In embodiments, the facility efficiency calculation unit may calculate the HVAC information ($H$) based on fan speed information of the HVAC.

In embodiments, the facility efficiency calculation unit may calculate the consumption power information ($P_C$) according to Equation 1

$$P_C = (C_1 + H + F_1) \times \frac{1}{C_{rate}}$$

in which $F_1$ is other facility information.

In embodiments, the facility efficiency calculation unit may calculate the facility efficiency information ($F_E$) according to Equation 2

$$F_E = 1 - \frac{P_C}{D_C} \times 100$$

in which $D_C$ is battery design capacity information.

In embodiments, the UDE calculation unit may calculate the UDE according to Equation 3

$$UDE = D_C[kWh] \times S_{OC}[\%] \times C_{rate}[\%] \times F_E[\%]$$
.

In embodiments, when the charging mode determination unit determines that the battery is being charged, the SOC calculation unit may calculate the SOC ($S_{oc}$) and then transmits the SOC ($S_{oc}$) to an energy management system (EMS).

A method of providing usable discharge energy (UDE) information based on consumption power, according to an embodiment of the present disclosure, includes calculating, by an SOC calculation unit, an SOC of a battery, calculating, by a discharge efficiency calculation unit, discharge efficiency ($C_{rate}$) information by receiving battery discharge current information, calculating, by a facility efficiency calculation unit, facility efficiency information ($F_E$) by receiving chiller ($C_1$) information and heating, ventilation & conditioning (HVAC) ($H$) information, and calculating, by a UDE calculation unit, a usable discharge energy (UDE) based on the SOC ($S_{oc}$), the discharge efficiency ($C_{rate}$) information, and the facility efficiency information ($F_E$).

In embodiments, the method of providing usable discharge energy (UDE) information based on consumption power may further include identifying, by a charging mode determination unit, a battery charging state. The identifying of the battery charging state may include calculating the UDE when the charging mode determination unit determines that the battery is not being charged.

In embodiments, the calculating of the facility efficiency information may include calculating the chiller information ($C_1$) based on fan speed and LPM information of the chiller.

In embodiments, the calculating of the facility efficiency information may include calculating the HVAC information ($H$) based on fan speed information of the HVAC.

In embodiments, the calculating of the facility efficiency information may include calculating the consumption power information ($P_C$) according to Equation 1

$$P_C = (C_1 + H + F_1) \times \frac{1}{C_{rate}}$$

in which $F_1$ is other facility information.

In embodiments, the calculating of the facility efficiency information may include calculating the facility efficiency information ($F_E$) according to Equation 2

$$F_E = 1 - \frac{P_C}{D_C} \times 100$$

In which $D_C$ is battery design capacity information.

In embodiments, the calculating of the UDE may include calculating the UDE according to Equation 3

$$UDE = D_C[kWh] \times S_{OC}[\%] \times C_{rate}[\%] \times F_E[\%]$$

In embodiments, the identifying of the battery charging state may include calculating, by the SOC calculation unit, the SOC ($S_{oc}$) and then transmitting the SOC ($S_{oc}$) to an energy management system (EMS) when the charging mode determination unit determines that the battery is being charged.

A battery management system configured to be used in the system for providing UDE information based on consumption power, according to an embodiment of the present disclosure, includes a state-of-charge (SOC) calculation unit configured to calculate an SOC ($S_{oc}$) of a battery, a discharge efficiency calculation unit configured to calculate

discharge efficiency ($C_{rate}$) information by receiving battery discharge current information, a facility efficiency calculation unit configured to calculate facility efficiency information ($F_E$) by receiving chiller ($C_1$) information and heating, ventilation & conditioning (HVAC) ($H$) information, and a usable discharge energy (UDE) calculation unit configured to calculate UDE based on the SOC ($S_{oc}$), the discharge efficiency ($C_{rate}$) information, and the facility efficiency information ($F_E$).

In embodiments, the battery management system may further include a charging mode determination unit configured to identify a battery charging state. When the charging mode determination unit determines that the battery is not being charged, the UDE is calculated.

According to embodiments of the present disclosure, SOC information of a battery that may be discharged to a grid in an ESS operation is determined by providing information obtained by calculating consumption power value of an air-conditioning system of a product depending on a battery operation mode.

However, aspects and features of the present disclosure are not limited to those described above, and other aspects and features not mentioned will be clearly understood by a person skilled in the art from the detailed description, described below.

At least some of the above and other features of the invention are set out in the claims.

## BRIEF DESCRIPTION OF THE DRAWINGS

The following drawings attached to this specification illustrate embodiments of the present disclosure and provide a further understanding of the technical scope of the present disclosure along with the aforementioned contents of the disclosure. Accordingly, the present disclosure should not be construed as being limited to the contents described in the drawings, in which:

FIG. 1 is a block diagram of a system for providing the SOC of a battery in a conventional ESS product and a system for providing usable discharge energy (UDE) information according to embodiments of the present disclosure.

FIG. 2 is a block diagram of a system for providing UDE information based on consumption power according to embodiments of the present disclosure.

FIG. 3 is a flowchart describing a method of UDE information based on consumption power according to embodiments of the present disclosure.

FIG. 4 is a table illustrating battery efficiency of an ESS system according to outdoor temperatures and outputs and examples thereof with respect to consumption power according to embodiments of the present disclosure.

FIG. 5 is a table illustrating examples of the calculation of product consumption power according to chiller and HVAC information and other facility discharge outputs according to embodiments of the present disclosure.

## DETAILED DESCRIPTION

Embodiments of the present disclosure will be described below, in detail, with reference to the accompanying drawings. Prior to the description, it is noted that the terms or words used in this specification and claims should not be construed as being limited to common or dictionary meanings but instead should be understood to have meanings and concepts in agreement with the scope of the present disclosure based on the principle that an inventor can define the concept of each term suitably in order to describe his/her own invention in the best way possible. Accordingly, because the embodiments described in this specification and the configurations illustrated in the drawings are only examples of aspects and features of the present disclosure and do not cover all the technical ideas of the present disclosure, it should be understood that various changes and modifications may be made at the time of filing this application.

It will be further understood that the terms "comprises/includes" and/or "comprising/including" when used herein, specify the presence of stated features, integers, steps, operations, elements, components, and/or groups thereof, but do not preclude the presence or addition of one or more other features, integers, steps, operations, elements, components, and/or groups thereof.

To facilitate understanding of the present disclosure, the accompanying drawings are not drawn to scale and the dimensions of some components may be exaggerated. It should be noted that the same reference numerals are designated to the same components in different embodiments.

Reference to two compared elements, features, etc. as being "the same" means that they are "substantially the same". Therefore, the phrase "substantially the same" may include a deviation that is considered low in the art, for example, a deviation of about 5% or less. The uniformity of any parameter in a given region may mean that it is uniform from an average perspective.

Although the terms such as "first" and/or "second" are used to describe various components, these components are not limited by these terms, of course. These terms are only used to distinguish one component from another component. Thus, unless specifically stated to the contrary, a first component may be termed a second component without departing from the teachings of example embodiments.

Throughout the specification, unless otherwise stated, each element may be singular or plural.

Arrangement of any component "above (or below)" or "on (or under)" a component may mean that any component is disposed in contact with the upper (or lower) surface of the component, as well as that other components may be interposed between the element and any element disposed on (or under) the element.

It will be understood that, when a component is referred to as being "connected", "coupled", or "joined" to another component, not only can it be directly "connected", "coupled", or "joined" to the other element, but also can it be indirectly "connected", "coupled", or "joined" to the other element with other elements interposed therebetween.

As used herein, the term "and/or" includes any and all combinations of one or more of the associate listed items. The use of "may" when describing embodiments of the present disclosure relates to "one or more embodiments of the present disclosure". Expressions such as "at least one" and "one or more" preceding a list of elements modify the entire list of elements and do not modify the individual elements in the list.

Throughout the specification, when "A and/or B" is stated, it means A, B, or A and B, unless otherwise stated. In addition, when "C to D" is stated, it means C or more and D or less, unless specifically stated to the contrary.

When the phrase such as "at least one of A, B, and C", "at least one of A, B, or C", "at least one selected from the group of A, B, and C", or "at least one selected from among A, B, and C" is used to designate a list of elements A, B, and C, the phrase may refer to any and all suitable combinations.

The term "use" may be considered synonymous with the term "utilize". As used herein, the terms "substantially," "about," and similar terms are used as terms of approximation rather than as terms of degree, and are intended to account for inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, component, region, layer, or section discussed below may be termed a second element, component, region, layer, or section without departing from the teachings of example embodiments.

For ease of explanation in describing the relationship of one element or feature to another element(s) or feature(s) as illustrated in the drawings, spatially relative terms such as "beneath", "below", "lower", "above", and "upper" may be used herein. It will be understood that spatially relative positions are intended to encompass different directions of the device in use or operation in addition to the direction depicted in the drawings. For example, if the device in the drawings is turned over, any element described as being "below" or "beneath" another element would then be oriented "above" or "over" another element. Therefore, the term "below" may encompass both upward and downward directions.

The terminology used herein is for the purpose of describing embodiments of the present disclosure and is not intended to limit the present disclosure.

The system and/or any other relevant devices or components, including devices and components of the system, according to embodiments of the present disclosure described herein may be implemented utilizing any suitable hardware, firmware (e.g., an application-specific integrated circuit), software, and/or a suitable combination of software, firmware, and hardware. For example, the various components of the system may be formed on one integrated circuit (IC) chip or on separate IC chips. Further, the various components of the system may be implemented on a flexible printed circuit film, a tape carrier package (TCP), a printed circuit board (PCB), or formed on a same substrate as the system. Further, the various components of the system may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device or the functionality of a particular computing device may be distributed across one or more other computing devices without departing from the scope of the example embodiments of the present disclosure.

The present invention will be described in detail with reference to the attached drawings below.

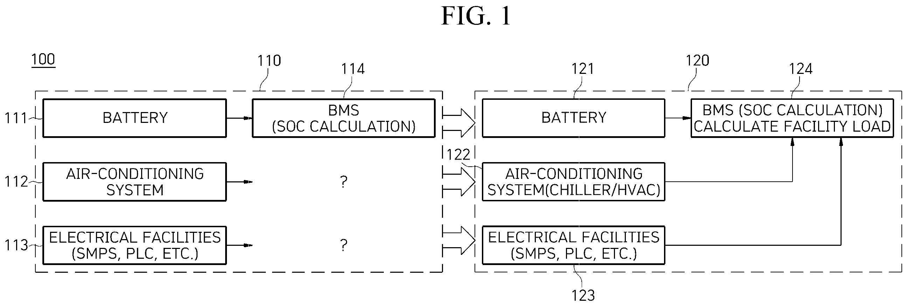

FIG. 1 is a block diagram of a system for providing the SOC ($S_{oc}$) of a battery in a conventional ESS product and a system for providing usable discharge energy (UDE) information according to embodiments of the present disclosure.

Referring to FIG. 1, generally, in an ESS product of a container unit, a BMS may perform monitoring, control, and SOC operations in a product operation. Furthermore, in addition to the provision of SOC information, additional information may be provided by calculating consumption power of an air-conditioning system and electrical facility of the ESS product.

In a conventional ESS operation, the state of charge (SOC) of a battery is a very important factor and is provided by using various SOC operation algorithms based on a cell voltage, temperature, and current of a battery but does not provide usable discharge energy (UDE) information based on actual consumption power.

The system 110 for providing the SOC of a battery in a conventional ESS product may include a battery 111, an air-conditioning system 112, an electrical facility 113, and a battery management system (BMS) 114. The system 110 for providing the SOC of a battery in the conventional ESS product may provide the SOC ($S_{oc}$) of a battery by calculating the SOC of the battery through (or by using) BMS 114 based on only information that is received from the battery 111 other than consumption power information of the air-conditioning system 112 and the electrical facility 113.

In contrast, a system 120 for providing UDE information according to embodiments of the present disclosure may include components, such as a battery 121, an air-conditioning system 122, an electrical facility 123, and a BMS 124 but may perform an SOC operation and a facility load operation through (or by using) the BMS 124 by additionally receiving consumption power information of the air-conditioning system 122 and the electrical facility 123 along with information of the battery 121. In such an embodiment, the air-conditioning system 112, 122 may include a chiller ($C_1$) and heating ventilation and air conditioning (HVAC). The electrical facility 113, 123 may include a switching mode power supply (SMPS) and power line communication (PLC).

The BMS may provide information of consumption power by calculating a load of all of the facilities of an ESS product, and usable discharge energy (UDE) may be considered from an ESS operation perspective. In such an embodiment, facility efficiency may refer to the amount of power that is consumed by an operation of a facility during a battery operation.

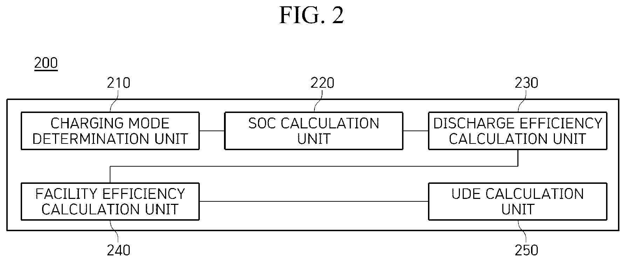

FIG. 2 is a block diagram of a system 200 for providing UDE information based on consumption power according to embodiments of the present disclosure.

Referring to FIG. 2, the system 200 for providing usable discharge energy (UDE) information based on consumption power may include a charging mode determination unit 210, an SOC calculation unit 220, a discharge efficiency calculation unit 230, a facility efficiency calculation unit 240, and a UDE calculation unit 250.

When an energy management system (EMS) requests a battery management system (BMS) to calculate UDE information, the charging mode determination unit 210 may determine whether or not the state of a battery is a charging state, may determine that the battery is in a charging mode when the battery is being charged, may calculate the SOC ($S_{oc}$) of the battery, and may transmit the calculated SOC ($S_{oc}$) to the EMS. In this case, the SOC ($S_{oc}$) is different from UDE according to embodiments of the present disclosure. The UDE according to embodiments of the present disclosure may be calculated when a battery is not being charged.

When the charging mode determination unit 210 determines that the battery is not being charged, the SOC calculation unit 220 may calculate the current SOC ($S_{oc}$) of the battery.

The discharge efficiency calculation unit 230 may calculate discharge efficiency ($C_{rate}$) information by receiving battery discharge current information.

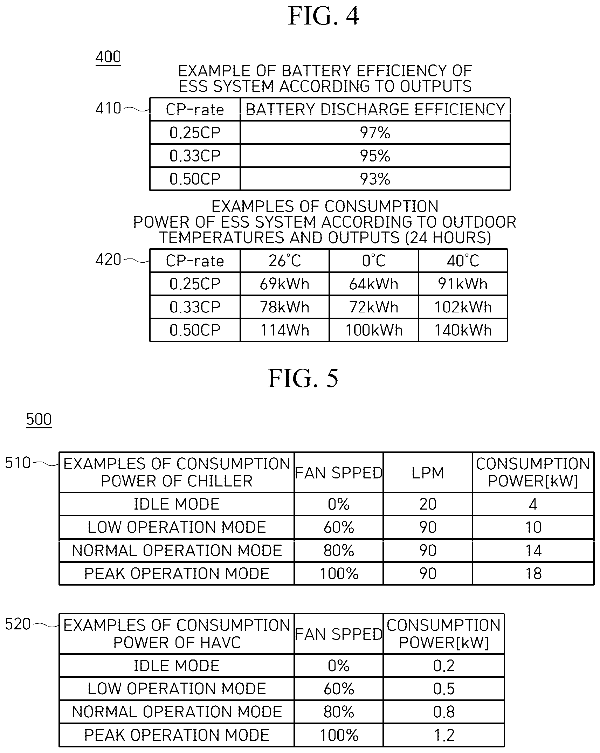

The discharge efficiency ($C_{rate}$) information is described with reference to FIG. 4. FIG. 4 is a table illustrating battery efficiency of an ESS system according to outdoor temperatures and outputs and examples thereof with respect to consumption power according to embodiments of the present disclosure.

Referring to FIG. 4, in the example table 410 of battery efficiency of the ESS system, battery discharge efficiency is 97% when a discharging current is 0.25CP, battery discharge efficiency is 95% when a discharging current is 0.33CP, and battery discharge efficiency is 93% when a discharging current is 0.50CP. In this case, SOC information of a battery and the battery discharge efficiency may be obtained based on SOC operation information and discharge current information of each rack from a battery rack.

Referring back to FIG. 2, the facility efficiency calculation unit 240 may calculate facility efficiency information ($F_E$) by receiving chiller ($C_1$) information and heating, ventilation & conditioning (HVAC) (H) information. In such an embodiment, discharge efficiency ($C_{rate}$) may only be received, and only the chiller ($C_1$) information and the HVAC information (H) may be used when the facility efficiency information ($F_E$) is calculated.

The calculation of the facility efficiency information ($F_E$) is described with reference to FIG. 5. FIG. 5 is a table illustrating an example of the calculation of product consumption power according to chiller ($C_1$) information, HVAC information (H), and discharge outputs of other facilities ($F_1$) according to embodiments of the present disclosure.

Chiller information may be calculated based on fan speed and Litres Per Minute (LPM) information, and an example table 510 thereof is illustrated in FIG. 5. Consumption power may be different depending on an operation mode of the chiller. The operation mode may be divided into an idle mode, a low operation mode, a normal operation mode, and a peak operation mode. In the idle mode, data of consumption power 4 kW may be obtained based on a fan speed of 0% and LPM of 20. In the low operation mode, data of consumption power 10 kW may be obtained based on a fan speed of 60% and LPM of 90. In the normal operation mode, data of consumption power 14 kW may be obtained based on a fan speed of 80% and LPM of 90. Finally, in the peak operation mode, data of consumption power 18 kW may be obtained based on a fan speed of 100% and LPM of 90. In this case, the chiller information may refer to chiller consumption power information.

Furthermore, HVAC information may be calculated based on fan speed information, and an example table 520 thereof is illustrated in FIG. 5. Consumption power of HVAC may be different depending on an operation mode. The operation mode may be divided into the idle mode, the low operation mode, the normal operation mode, and the peak operation mode. In the idle mode, data of consumption power 0.2 kW may be obtained based on a fan speed of 0%. In the low operation mode, data of consumption power 0.5 kW may be obtained based on a fan speed of 60%. In the normal operation mode, data of consumption power 0.8 kW may be obtained based on a fan speed of 80%. Finally, in the peak operation mode, data of consumption power 1.2 kW may be obtained based on a fan speed of 100%. In this case, the HVAC information may refer to HVAC consumption power information.

In this case, the consumption power may be calculated according to Equation 1.

Equation 1:

$$P_C = (C_1 + H + F_1) \times \frac{1}{C_{rate}}$$

In Equation 1, $C_{rate}$ refers to a discharge current. Other facilities include a switching mode power supply (SMPS) and power line communication (PLC). After a fixed variable value is obtained, the fixed variable value may be substituted. The fixed variable value does not need to be unconditionally substituted.

Thereafter, the facility efficiency information ($F_E$) may be calculated by multiplying a value, which is obtained by dividing the consumption power information ($P_C$) by battery design capacity information ($D_C$), by 100 and subtracting the value from 1.

The facility efficiency information ($F_E$) may be calculated according to Equation 2.

Equation 2:

$$F_E = 1 - \frac{P_C}{D_C} \times 100$$

Referring back to FIG. 2, the UDE calculation unit 250 may calculate usable discharge energy (UDE) information based on the SOC ($S_{oc}$), the discharge efficiency ($C_{rate}$) information, and the facility efficiency information ($F_E$).

The UDE information may be calculated according to Equation 3.

Equation 3:

$$UDE = D_C[kWh] \times S_{OC}[\%] \times C_{rate}[\%] \times F_E[\%]$$

For example, referring to the table of FIG. 4, if discharging at 0.5CP occurs at an external temperature of 23°C in an ESS operation environment in the state in which a battery capacity is a 5 MWh unit container and the SOC of a battery of 50%, UDE may be calculated as 2.5 MWh x 93% x 98.62% = 2,292.9 kWh (i.e., an actual discharge quantity).

The UDE calculated through the UDE calculation unit 250 may be transmitted to the EMS.

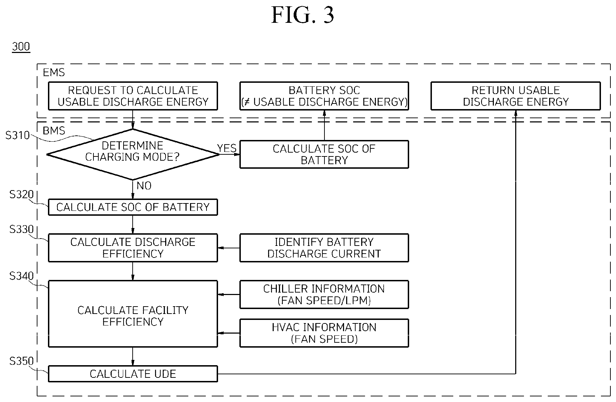

FIG. 3 is a flowchart describing a method of providing UDE information based on consumption power according to embodiments of the present disclosure.

Referring to FIG. 3, the method of providing usable discharge energy (UDE) information based on consumption power may include a charging mode determination step S310, an SOC calculation step S320, a discharge efficiency calculation step 330, a facility efficiency calculation step 340, and a UDE calculation step 350.

When an energy management system (EMS) requests a battery management system (BMS) to calculate UDE information, the charging mode determination unit 210 may determine whether or not the state of a battery is a charging state, may determine that the battery is in the charging mode when the battery is being charged, may calculate the SOC ($S_{oc}$) of the battery, and may transmit the calculated SOC ($S_{oc}$) to the EMS. In this case, the SOC ($S_{oc}$) is different from UDE according to embodiments of the present disclosure. The UDE according to embodiments of the present disclosure may be calculated when a battery is not being charged (S310).

When the charging mode determination unit 210 determines that the battery is not being charged, the SOC calculation unit 220 may calculate the current SOC ($S_{oc}$) of the battery (S320).

The discharge efficiency calculation unit 230 may calculate discharge efficiency ($C_{rate}$) information by receiving battery discharge current information (S330).

The facility efficiency calculation unit 240 may calculate facility efficiency information ($F_E$) by receiving chiller ($C_1$) information and heating, ventilation & conditioning (HVAC) ($H$) information (S340).

The UDE calculation unit 250 may calculate UDE, based on the SOC ($S_{oc}$), the discharge efficiency ($C_{rate}$) information, and the facility efficiency information ($F_E$) (S350).

The UDE calculated through the UDE calculation unit 250 may be transmitted to the EMS.

A conventional battery storage system of a container unit provides only SOC information based on the calculation of the SOC of a battery. In contrast, according to the embodiments of the present disclosure, SOC information of a battery is provided in a form which may be discharged to a grid in an ESS operation by providing information obtained by calculating consumption power value of an air-conditioning system of a product depending on a battery operation mode.

Although the present disclosure has been described above in connection with some embodiments, the present disclosure is not limited to the embodiments. A person having ordinary knowledge in the art to which the present disclosure pertains may modify and change the present disclosure within the technical scope of the present disclosure and the equivalent range of the following claims.

**Description of Symbols**

200: system for providing UDE information based on consumption power
210: charging mode determination unit
220: SOC calculation unit
230: discharge efficiency calculation unit
240: facility efficiency calculation unit
250: UDE calculation unit

**Claims**

1. A system for providing usable discharge energy (UDE) information based on consumption power, the system comprising:

   a state of charge (SOC) calculation unit configured to calculate an SOC ($S_{oc}$) of a battery;
   a discharge efficiency calculation unit configured to calculate discharge efficiency ($C_{rate}$) information by receiving battery discharge current information;
   a facility efficiency calculation unit configured to calculate facility efficiency information ($F_E$) by receiving chiller ($C_1$) information and heating, ventilation & conditioning (HVAC) (H) information; and
   a UDE calculation unit configured to calculate UDE based on the SOC ($S_{oc}$), the discharge efficiency ($C_{rate}$) information, and the facility efficiency information ($F_E$).

2. The system as claimed in claim 1, further comprising a charging mode determination unit configured to identify a battery charging state,
   wherein the UDE calculation unit calculates the UDE when the charging mode determination unit determines that the battery is not being charged.

3. The system as claimed in claim 2, wherein, when the charging mode determination unit determines that the battery is being charged, the SOC calculation unit calculates the SOC ($S_{oc}$) and then transmits the SOC ($S_{oc}$) to an energy management system (EMS).

4. The system as claimed in any preceding claim, wherein the facility efficiency calculation unit calculates the chiller information ($C_1$) based on fan speed and LPM information of the chiller.

5. The system as claimed in any preceding claim, wherein the facility efficiency calculation unit calculates the HVAC information (H) based on fan speed information of the HVAC.

6. The system as claimed in any preceding claim, wherein the facility efficiency calculation unit calculates the consumption power information ($P_C$) according to Equation 1

$$P_C = (C_1 + H + F_1) \times \frac{1}{C_{rate}}$$

wherein $F_1$ is other facility information,

optionally wherein the facility efficiency calculation unit calculates the facility efficiency information ($F_E$) according to Equation 2

$$F_E = 1 - \frac{P_C}{D_C} \times 100$$

wherein $D_C$ is battery design capacity information.

**7.** The system as claimed in any preceding claim, wherein the UDE calculation unit calculates the UDE according to Equation 3

$$UDE = D_C[kWh] \times S_{OC}[\%] \times C_{rate}[\%] \times F_E[\%]$$

wherein $D_C$ is battery design capacity information.

**8.** A method of providing usable discharge energy (UDE) information based on consumption power, the method comprising:

calculating, by an SOC calculation unit, a state-of-charge (SOC) ($S_{oc}$) of a battery;
calculating, by a discharge efficiency calculation unit, discharge efficiency ($C_{rate}$) information by receiving battery discharge current information;
calculating, by a facility efficiency calculation unit, facility efficiency information ($F_E$) by receiving chiller ($C_1$) information and heating, ventilation & conditioning (HVAC) ($H$) information; and
calculating, by a UDE calculation unit, usable discharge energy (UDE) based on the SOC ($S_{oc}$), the discharge efficiency ($C_{rate}$) information, and the facility efficiency information ($F_E$).

**9.** The method as claimed in claim 8, further comprising identifying, by a charging mode determination unit, a battery charging state,
wherein the identifying of the battery charging state comprises calculating the UDE when the charging mode determination unit determines that the battery is not being charged.

**10.** The method as claimed in claim 8 or claim 9, wherein the calculating of the facility efficiency information comprises calculating the chiller information ($C_1$) based on fan speed and LPM information of the chiller; and/or
wherein the calculating of the facility efficiency information comprises calculating the HVAC information ($H$) based on fan speed information of the HVAC.

**11.** The method as claimed in any of claims 8-10, wherein the calculating of the facility efficiency information comprises calculating the consumption power information ($P_C$) according to Equation 1

$$P_C = (C_1 + H + F_1) \times \frac{1}{C_{rate}}$$

wherein $F_1$ is other facility information,
optionally wherein the calculating of the facility efficiency information comprises calculating the facility efficiency information ($F_E$) according to Equation 2

$$F_E = 1 - \frac{P_C}{D_C} \times 100$$

wherein $D_C$ is battery design capacity information.

**12.** The method as claimed in any of claims 8-11, wherein the calculating of the UDE comprises calculating the UDE according to Equation 3

$$UDE = D_C[kWh] \times S_{OC}[\%] \times C_{rate}[\%] \times F_E[\%]$$

wherein $D_C$ is battery design capacity information.

13. The method as claimed in any of claims 9 to 12, wherein the identifying of the battery charging state comprises calculating, by the SOC calculation unit, the SOC ($S_{oc}$) and then transmitting the SOC ($S_{oc}$) to an energy management system (EMS) when the charging mode determination unit determines that the battery is being charged.

14. A battery management system configured to be used in a system for providing usable discharge energy (UDE) information based on consumption power, the battery management system comprising:

a state-of-charge (SOC) calculation unit configured to calculate an SOC ($S_{oc}$) of a battery;
a discharge efficiency calculation unit configured to calculate discharge efficiency ($C_{rate}$) information by receiving battery discharge current information;
a facility efficiency calculation unit configured to calculate facility efficiency information ($F_E$) by receiving chiller ($C_1$) information and heating, ventilation & conditioning (HVAC) ($H$) information; and
a usable discharge energy (UDE) calculation unit configured to calculate UDE based on the SOC ($S_{oc}$), the discharge efficiency ($C_{rate}$) information, and the facility efficiency information ($F_E$).

15. The battery management system as claimed in claim 14, further comprising a charging mode determination unit configured to identify a battery charging state,
wherein, when the charging mode determination unit determines that the battery is not being charged, the UDE is calculated.

# FIG. 1

FIG. 2

200

210                        220                        230

| CHARGING MODE DETERMINATION UNIT | SOC CALCULATION UNIT | DISCHARGE EFFICIENCY CALCULATION UNIT |
|---|---|---|
| FACILITY EFFICIENCY CALCULATION UNIT | | UDE CALCULATION UNIT |

240                                         250

## FIG. 3

300

EMS

| REQUEST TO CALCULATE USABLE DISCHARGE ENERGY | BATTERY SOC (≠ USABLE DISCHARGE ENERGY) | RETURN USABLE DISCHARGE ENERGY |

BMS

S310 — DETERMINE CHARGING MODE? — YES → CALCULATE SOC OF BATTERY

NO

S320 — CALCULATE SOC OF BATTERY

S330 — CALCULATE DISCHARGE EFFICIENCY ← IDENTIFY BATTERY DISCHARGE CURRENT

S340 — CALCULATE FACILITY EFFICIENCY ← CHILLER INFORMATION (FAN SPEED/LPM)
← HVAC INFORMATION (FAN SPEED)

S350 — CALCULATE UDE

# FIG. 4

400

EXAMPLE OF BATTERY EFFICIENCY OF
ESS SYSTEM ACCORDING TO OUTPUTS

410

| CP-rate | BATTERY DISCHARGE EFFICIENCY |
|---------|------------------------------|
| 0.25CP  | 97% |
| 0.33CP  | 95% |
| 0.50CP  | 93% |

EXAMPLES OF CONSUMPTION
POWER OF ESS SYSTEM ACCORDING TO OUTDOOR
TEMPERATURES AND OUTPUTS (24 HOURS)

420

| CP-rate | 26°C | 0°C | 40°C |
|---------|------|-----|------|
| 0.25CP  | 69kWh | 64kWh | 91kWh |
| 0.33CP  | 78kWh | 72kWh | 102kWh |
| 0.50CP  | 114Wh | 100kWh | 140kWh |

# FIG. 5

500

510

| EXAMPLES OF CONSUMPTION POWER OF CHILLER | FAN SPPED | LPM | CONSUMPTION POWER[kW] |
|------------------------------------------|-----------|-----|------------------------|
| IDLE MODE | 0% | 20 | 4 |
| LOW OPERATION MODE | 60% | 90 | 10 |
| NORMAL OPERATION MODE | 80% | 90 | 14 |
| PEAK OPERATION MODE | 100% | 90 | 18 |

520

| EXAMPLES OF CONSUMPTION POWER OF HAVC | FAN SPPED | CONSUMPTION POWER[kW] |
|---------------------------------------|-----------|------------------------|
| IDLE MODE | 0% | 0.2 |
| LOW OPERATION MODE | 60% | 0.5 |
| NORMAL OPERATION MODE | 80% | 0.8 |
| PEAK OPERATION MODE | 100% | 1.2 |

**EUROPEAN SEARCH REPORT**

Application Number

EP 25 19 9209

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2015/112497 A1 (STEVEN ALAIN P [US] ET AL) 23 April 2015 (2015-04-23)<br>* abstract *<br>* paragraph [0130] - paragraph [0162] *<br>* paragraph [0400] - paragraph [0423] *<br>----- | 1-15 | INV.<br>H02J3/32<br>H02J7/82<br>H02J7/90<br>H02J7/94 |
| A | TAYLOR ZACHARIAH ET AL: "Optimal Operation of Grid-Tied Energy Storage Systems Considering Detailed Device-Level Battery Models",<br>IEEE TRANSACTIONS ON INDUSTRIAL INFORMATICS, IEEE SERVICE CENTER, NEW YORK, NY, US,<br>vol. 16, no. 6,<br>5 September 2019 (2019-09-05), pages 3928-3941, XP011777057,<br>ISSN: 1551-3203, DOI:<br>10.1109/TII.2019.2939621<br>[retrieved on 2020-03-05]<br>* abstract *<br>* SECTIONS "I. INTRODUCTION", "A. Background and Motivation" *<br>* page 3931, right-hand column, paragraph third *<br>----- | 1-15 | |
| A | CN 115 542 167 A (STATE GRID JIANGSU ECONOMIC RES INST ET AL.)<br>30 December 2022 (2022-12-30)<br>* abstract *<br>* paragraph [0007] - paragraph [0041] *<br>----- | 1-15 | TECHNICAL FIELDS SEARCHED (IPC)<br><br>H02J |
| A | CN 109 507 599 A (BEIJING BENZ AUTOMOTIVE CO LTD) 22 March 2019 (2019-03-22)<br>* abstract *<br>----- | 1-15 | |

The present search report has been drawn up for all claims

| Place of search | Date of completion of the search | Examiner |
|---|---|---|
| Munich | 28 January 2026 | Hurtado-Albir, F |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 19 9209

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2026

| Patent document cited in search report | Publication date | Patent family member(s) | | Publication date |
|---|---|---|---|---|
| US 2015112497 A1 | 23-04-2015 | US | 2015088576 A1 | 26-03-2015 |
| | | US | 2015112497 A1 | 23-04-2015 |
| | | WO | 2013166510 A1 | 07-11-2013 |
| | | WO | 2013166511 A2 | 07-11-2013 |
| CN 115542167 A | 30-12-2022 | NONE | | |
| CN 109507599 A | 22-03-2019 | NONE | | |

EPO FORM P0459

For more details about this annex : see Official Journal of the European Patent Office, No. 12/82